# DEMANDE DE BREVET EUROPEEN

(11) **EP 4 375 617 A1**
(43) Date de publication de la demande: **29.05.2024**
(21) Numéro de dépôt: 23306989.7
(22) Date de dépôt: 17.11.2023
(51) Int. Cl.: G01C 21/14, A47L 9/00, G01C 21/00, G01S 5/02

(54) **PROCEDE POUR ETABLIR UNE CARTOGRAPHIE D'UN PARAMETRE DANS UNE ZONE A PARTIR D'UN CAPTEUR MONTE SUR UN ROBOT AUTONOME**

(30) Priorité: 25.11.2022 FR 2212343
(71) Demandeur: Orange, 92130 Issy-les-Moulineaux (FR)
(72) Inventeur: AVENEL, Loïc, 92326 CHATILLON CEDEX (FR); ESNAULT, Régis, 92326 CHATILLON CEDEX (FR)
(74) Mandataire: Plasseraud IP

(57) **Abrégé**

Procédé d'obtention de données de mesures d'au moins un paramètre, à partir d'au moins un capteur (102), dans lequel ledit capteur (102) est monté sur un dispositif de type robot (101, 101') apte à se déplacer dans une zone pour opérer une première fonction, le procédé comportant :
- activer (202) le capteur (102) pour mesurer le paramètre au moins pendant un déplacement du dispositif (101, 101') dans la zone, et
- acquérir (203), selon une deuxième fonction du dispositif (101, 101'), distincte de la première fonction, des données pour établir une cartographie (401) dudit paramètre dans la zone.

## Description

### Domaine technique

La présente divulgation relève du domaine de la cartographie d'un paramètre.

Plus particulièrement, la présente divulgation porte sur un procédé pour établir une cartographie d'un paramètre dans une zone à partir d'un capteur monté sur un robot autonome.

### Technique antérieure

La cartographie de l'intensité d'un signal wifi propagé dans une zone définie peut s'avérer utile, par exemple dans une optique d'amélioration de l'intensité du signal wifi ou pour trouver le meilleur endroit pour l'installation d'un répéteur wifi.

Pour l'établissement d'une cartographie de l'intensité de signal wifi, il faut disposer d'outils tels qu'un capteur wifi et une interface numérique de contrôle. La zone à cartographier doit être parcouru par un technicien qui a une connaissance de ces outils afin d'extraire une cartographie de l'intensité de signal wifi précise.

Plus généralement, l'établissement d'une cartographie de l'intensité d'un signal issu d'un système tel qu'un chauffage, une ventilation, ou un émetteur wifi dans une zone intérieure ou extérieure nécessite l'utilisation d'outils spécifiques et l'intervention d'un technicien ayant des connaissances spécifiques de ces outils.

Des mesures régulières peuvent s'avérer nécessaire, par exemple pour analyser l'évolution temporelle du signal ou l'impact d'une variable sur l'intensité du signal.

Par exemple, dans le cas d'un signal wifi, des mesures peuvent être faites dans une pièce en fonction de la position d'un objet donné présent dans la zone, ou en fonction de l'heure.

Les méthodes connues de cartographie présentent des inconvénients.

Notamment, l'intervention régulière d'un technicien ayant une connaissance des outils de cartographie à utiliser est nécessaire. Ces interventions doivent être répétée afin de mettre à jour la cartographie et afin de comprendre l'impact de différentes variables sur l'intensité du signal.

Une pluralité d'outils est requise en fonction du type de signal et du type de cartographie à établir.

Il existe donc un besoin d'un procédé efficace pour établir une cartographie de l'intensité d'un signal, sans que l'intervention d'un technicien soit nécessaire et sans que l'utilisation d'une pluralité d'outils soit requise.

### Résumé

A cet effet, il est divulgué un procédé d'obtention de données de mesures d'au moins un paramètre, à partir d'au moins un capteur, dans lequel ledit capteur est monté sur un dispositif de type robot apte à se déplacer dans une zone pour opérer une première fonction, le procédé comportant :
- activer le capteur pour mesurer le paramètre au moins pendant un déplacement du dispositif dans la zone, et
- acquérir, selon une deuxième fonction du dispositif, distincte de la première fonction, des données pour établir une cartographie dudit paramètre dans la zone.

Le procédé permet d'établir une cartographie du paramètre dans la zone.

Le procédé vise à répondre aux inconvénients cités précédemment et à proposer une obtention de données de mesures d'un paramètre sans que l'utilisation et le déplacement d'un dispositif individuel soit requis à cet effet. Un dispositif apte à opérer une première fonction, par exemple un aspirateur qui se déplace de manière autonome pour nettoyer un bâtiment, est utilisé. Le dispositif peut établir une cartographie de la zone pendant qu'il met en oeuvre la première fonction.

Le procédé proposé est innovant sur l'utilisation d'un dispositif ayant une première fonction distincte de la deuxième fonction pour établir une cartographie d'une zone.

Le procédé est, de plus, original, en ce qu'il permet l'établissement d'une cartographie de façon autonome et sans que l'utilisation d'outils conçus pour un type de signal particulier soit nécessaire. L'intervention d'un technicien n'est pas requise et le procédé peut être mis en oeuvre par une personne n'ayant pas de connaissances spécifiques relatives au dispositif.

Le procédé s'inscrit dans une stratégie de développement durable, en ce qu'un dispositif déjà existant est utilisé et sans que l'utilisation d'un dispositif supplémentaire soit nécessaire pour l'établissement de la cartographie.

Une zone peut être parcourue régulièrement par le dispositif, permettant de mettre à jour la cartographie, étudier l'évolution temporelle de la cartographie et analyser l'impact d'une variable sur la cartographie.

Dans un mode de réalisation, le capteur est activé pour mesurer le paramètre pendant le déplacement du dispositif dans la zone pour opérer ladite première fonction.

Le capteur peut être activé uniquement lorsqu'une cartographie du paramètre doit être établi dans la zone, réduisant ainsi l'énergie consommée par le dispositif et notamment par le capteur.

Dans un mode de réalisation, le paramètre est un paramètre parmi au moins une intensité de signal wifi, une température, un degré d'humidité, une pression, une intensité de lumière.

La cartographie de l'intensité de signal wifi peut permettre d'optimiser l'endroit où sont installés une passerelle wifi, une box Internet ou un répéteur. Des objets présents dans une zone peuvent être déplacés en fonction de la cartographie afin d'optimiser l'intensité de signal wifi à un emplacement donné dans la zone.

La cartographie de la température dans un bâtiment peut permettre de détecter et d'optimiser des isolations défaillantes des murs ou des fenêtres, ou d'optimiser l'utilisation du chauffage.

La cartographie du degré d'humidité dans une zone peut permettre de trouver un endroit de stockage physique optimal du dispositif, afin de préserver sa durée de vie par exemple.

La cartographie de la pression peut permettre de détecter la survenance d'évènements provoquant une variation de la pression dans une zone. Par exemple, il peut être déterminé si une fenêtre a été ouverte ou pas.

La cartographie d'une intensité de lumière dans une zone peut permettre de détecter la survenance d'évènements provoquant des changements relatifs à l'intensité de lumière dans la zone. Par exemple, il peut être possible de déterminer si une ampoule a été allumée ou éteinte.

Dans un mode de réalisation, l'acquisition des données pour établir la cartographie du paramètre utilise des données de topologie de la zone d'une carte numérique préenregistrée correspondant à une topologie de la zone.

Une connaissance préalable de la topologique de la zone à cartographier, et notamment une connaissance des obstacles présents dans la zone, permet un déplacement plus efficace et plus rapide du dispositif dans la zone.

La comparaison d'une cartographie courante à des cartographies établies antérieurement pour la même zone est facilitée.

Dans un mode de réalisation, le procédé comprend une mesure de données de topologie de la zone, par détermination de distances parcourues par le dispositif entre des obstacles présents dans la zone, pour obtenir une carte numérique de la zone.

Aucune connaissance préalable de la zone est requise. Par exemple, la topologie peut être déterminée grâce à des mesures de distances angulaires parcourues par des roues d'un aspirateur ou d'une tondeuse, d'un obstacle à l'autre, ou de temps de vol entre deux obstacles dans le cas d'un drone.

L'utilisation d'un dispositif supplémentaire afin de déterminer la topologie de la zone n'est pas nécessaire, et le dispositif déjà disponible est utilisé à cet effet.

Dans un mode de réalisation, le dispositif est reprogrammé pour utiliser les données de topologie de la zone, en vue d'une nouvelle fonction dans la mise en oeuvre de la première fonction.

Ainsi, la mise en oeuvre de la première fonction peut être optimisée par l'utilisation des données de topologie.

Par exemple, la cartographie du degré d'humidité dans une zone peut permettre de trouver un endroit de stockage physique optimal du dispositif, afin de préserver sa durée de vie.

Dans un mode de réalisation, au moins deux capteurs sont montés sur le dispositif de type robot, le procédé comprenant :
- activer un premier capteur monté sur le dispositif de type robot pour mesurer un premier paramètre à un emplacement donné du dispositif de type robot pendant un laps de temps prédéterminé ;
- activer un deuxième capteur différent du premier capteur et monté sur le dispositif de type robot pour mesurer un deuxième paramètre audit emplacement donné du dispositif de type robot pendant ledit laps de temps prédéterminé ;
- réitérer la mesure du premier paramètre et du deuxième paramètre, et déterminer une survenance d'un évènement ou une absence dudit évènement dans la zone, sur la base des mesures du premier paramètre et du deuxième paramètre.

La durée du laps de temps peut être choisie en fonction de l'application destinée.

L'utilisation d'au moins deux capteurs permet d'identifier des évènements non identifiables par un seul capteur.

Par exemple, un dispositif peut comprendre un capteur de température et un capteur de pression. Lorsque le capteur de température détecte une chute de température dans la zone, le capteur de pression peut être utilisé pour déterminer l'origine de la chute de température. Ainsi, il est possible de distinguer par exemple entre l'ouverture d'une fenêtre (provoquant une variation de la pression) et le réglage du chauffage dans la zone.

Dans un mode de réalisation, au moins trois capteurs sont montés sur le dispositif de type robot, le procédé comprenant en outre :
- activer un troisième capteur différent du premier capteur et du deuxième capteur et monté sur le dispositif de type robot pour mesurer un troisième paramètre audit emplacement donné du dispositif de type robot pendant ledit laps de temps ;
- réitérer la mesure du premier paramètre, du deuxième paramètre et du troisième paramètre, et déterminer une survenance d'un évènement ou une absence dudit évènement dans la zone, sur la base des mesures du premier paramètre, du deuxième paramètre et du troisième paramètre.

La durée du laps de temps peut être choisie en fonction de l'application destinée.

L'utilisation d'au moins trois capteurs permet d'identifier des évènements non détectables par un seul capteur ou par deux capteurs.

Par exemple, le premier capteur peut être un capteur de température, le second capteur peut être un capteur d'humidité et le troisième capteur peut être un capteur de lumière. Lorsque le capteur de température détecte une chute de température dans une zone, le capteur d'humidité et le capteur de lumière peuvent être utilisés pour déterminer l'origine de la chute de température.
Ainsi, il est possible de distinguer par exemple entre l'ouverture de la porte d'un frigo éclairé de l'intérieur (provoquant une augmentation du degré d'humidité et de l'intensité de lumière dans la zone) et l'ouverture d'une fenêtre.

Un autre aspect de la divulgation concerne un produit programme informatique comportant des instructions qui, lorsque ces instructions sont exécutées par un circuit de traitement, conduisent le circuit de traitement à mettre en oeuvre le procédé précité.

Ce programme peut utiliser n'importe quel langage de programmation (par exemple, un langage-objet ou autre), et être sous la forme d'un code source interprétable, d'un code partiellement compilé ou d'un code totalement compilé.

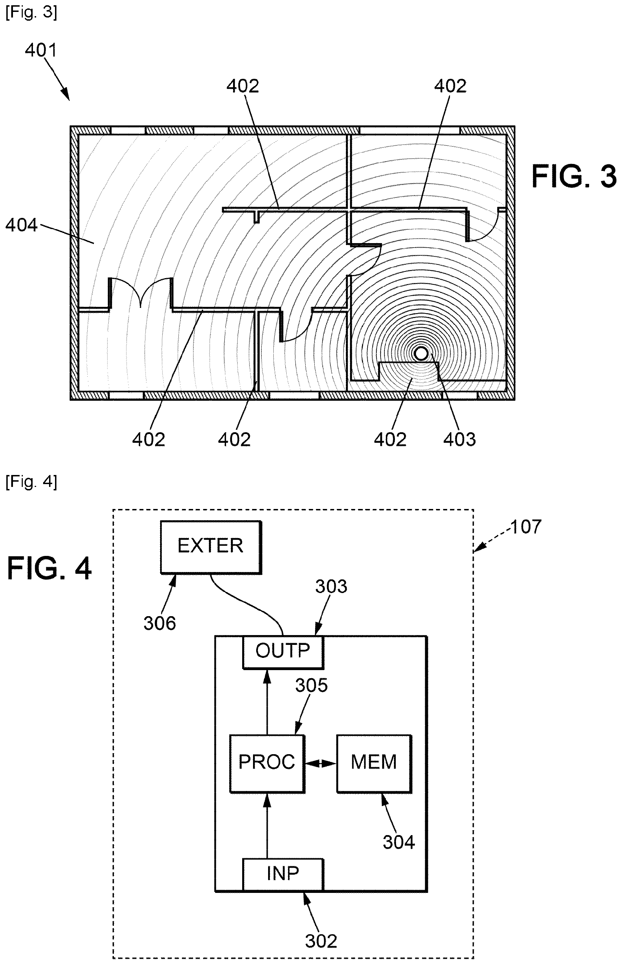

La figure 4 décrite en détail ci-après peut former l'organigramme de l'algorithme général d'un tel programme informatique.

Un autre aspect de la divulgation concerne un dispositif, de type robot, apte à se déplacer dans une zone pour opérer une première fonction, pour obtenir des données de mesures d'au moins un paramètre, le dispositif comportant un circuit de traitement configuré pour la mise en oeuvre du procédé précité.

Le circuit de traitement déjà présent dans le dispositif peut être utilisé pour la mise en oeuvre du procédé, minimisant le nombre d'outils supplémentaire requis pour la mise en oeuvre du procédé, dans une optique de développement durable.

Dans un mode de réalisation, le dispositif comporte en outre un module d'extension connecté au circuit de traitement et comportant :
* au moins un capteur configuré pour être activé et mesurer le paramètre au moins pendant un déplacement du dispositif dans la zone ;
* une interface d'acquisition configurée pour acquérir, selon la deuxième fonction du dispositif, les données pour établir une cartographie dudit paramètre dans la zone.

Ainsi, un dispositif déjà disponible peut être utilisé sans que des modifications majeures du dispositif soient nécessaires. Un module d'extension donné peut être utilisé en binôme avec différents types de dispositifs autonomes.

Par exemple, un même module d'extension peut être utilisé sur un aspirateur, sur une tondeuse et sur un drone, afin d'éviter la multiplication des capteurs et l'implantation d'un capteur dans chacun des dispositifs utilisés.

Le capteur peut être activé uniquement lorsqu'une cartographie du paramètre doit être établi dans la zone, réduisant ainsi l'énergie consommée par le dispositif.

Dans un mode de réalisation, le module d'extension comporte en outre un capteur de position configuré pour déterminer un emplacement du dispositif lors du déplacement dans la zone.

Ainsi, il n'est pas nécessaire d'intégrer un capteur de position dans chacun des dispositifs autonomes utilisés par un utilisateur.

Une tondeuse, un aspirateur, et un drone sans capteur de position peuvent être utilisés, et peuvent se servir du capteur de position du module d'extension.

Selon un autre aspect, il est également décrit un module d'extension configuré pour être connecté à un circuit de traitement d'un dispositif apte à se déplacer dans une zone pour opérer une première fonction, le module d'extension comportant :
* une interface de connexion configurée pour connecter le module d'extension au circuit de traitement du dispositif;
* au moins un capteur configuré pour être activé et mesurer au moins un paramètre pendant un déplacement du dispositif dans la zone ;
* une interface d'acquisition configurée pour acquérir, selon une deuxième fonction du dispositif, distincte de la première fonction, des données pour établir une cartographie dudit paramètre dans la zone.

Le module d'extension peut être utilisé en combinaison avec tout type de dispositif qui dispose d'une interface de réception adapté pour recevoir l'interface de connexion.

Dans un mode de réalisation, l'interface d'acquisition de données est connectée à un serveur distant et configurée pour transmettre au serveur distant les données acquises.

La cartographie peut être analysée à distance, par un fournisseur du dispositif ou par un fournisseur d'un signal dont un paramètre a été mesuré, et un diagnostic peut être établi.

Par exemple, la cartographie de l'intensité de signal wifi peut être analysé par un opérateur mobile mettant le signal wifi à la disposition d'un utilisateur. L'opérateur peut ensuite, en fonction du résultat du diagnostic, conseiller l'utilisateur, et lui indiquer le meilleur endroit pour l'installation de la box Internet ou du répéteur.

Dans un mode de réalisation, l'interface d'acquisition de données est connectée au circuit de traitement du dispositif pour transmettre audit circuit de traitement des données de cartographie dudit paramètre, le circuit de traitement étant programmé pour être configuré pour utiliser les données de cartographie pour réaliser la première fonction.

Ainsi, la mise en oeuvre de la première fonction par le dispositif peut être optimisée par l'utilisation des données de cartographie.

Par exemple, une cartographie du degré d'humidité dans une zone peut permettre de trouver un endroit de stockage physique optimal du dispositif, afin de préserver sa durée de vie.

### Brève description des dessins

D'autres caractéristiques, détails et avantages apparaîtront à la lecture de la description détaillée ci-après, et à l'analyse des dessins annexés, sur lesquels :
**Fig. 1a et Fig. 1b**

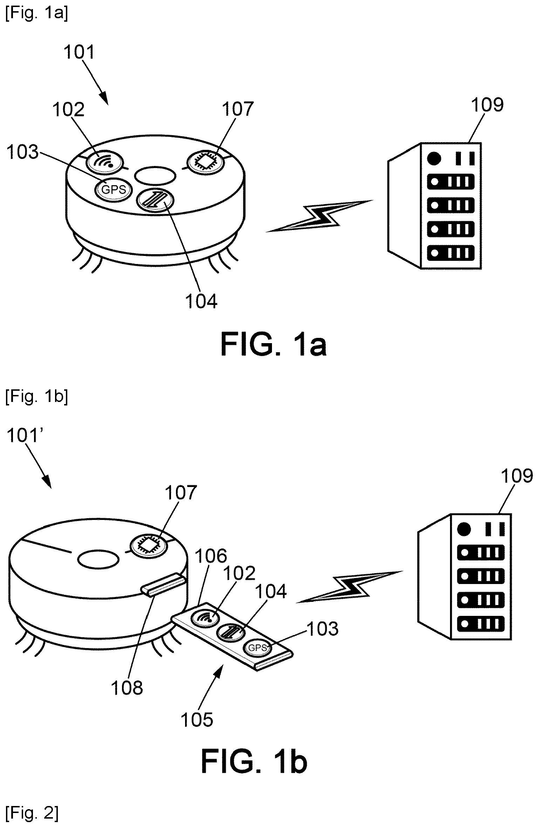

   [Fig. 1a] et [Fig. 1b] représentent schématiquement deux modes de réalisation d'un aspirateur apte à se déplacer de manière autonome dans une zone pour établir une cartographie d'un paramètre.
Fig. 2

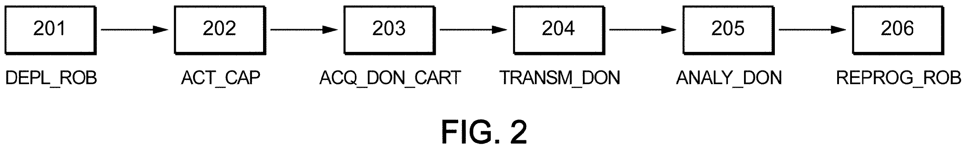

   [Fig. 2] représente un ordinogramme d'un procédé d'obtention de données de mesures d'un paramètre à partir d'un capteur monté sur un aspirateur pour établir une cartographie de la zone.
Fig. 3
   [Fig. 3] représente schématiquement une cartographie de l'intensité d'un signal wifi d'une zone établi par un aspirateur.
Fig. 4
   [Fig. 4] montre schématiquement un circuit de traitement adapté pour mettre en oeuvre le procédé d'obtention de données de mesures d'un paramètre à partir d'un capteur monté sur l'aspirateur pour établir une cartographie de la zone.

### Description des modes de réalisation

Il est décrit par la suite un procédé pour établir une cartographie d'un paramètre dans une zone.

Le procédé peut être mis en oeuvre par un dispositif de type robot, i.e. un robot qui peut se déplacer de manière autonome dans une zone, tel qu'un aspirateur, une tondeuse, un drone, ou un véhicule autonome guidé. Le robot peut remplir une première fonction, ex. nettoyer un bâtiment (pour le cas d'un aspirateur) ou tondre la pelouse (pour le cas d'une tondeuse).

En outre, le robot peut être configuré pour remplir une deuxième fonction distincte de la première fonction et établir une cartographie d'un paramètre à partir d'un capteur monté sur le robot. Par exemple, le robot peut, pendant l'exécution de la première fonction, établir une cartographie d'une intensité de signal wifi, d'une température, d'un degré d'humidité, une pression, ou une intensité de lumière dans la zone.

Dans un mode de réalisation non-limitatif, un aspirateur sur lequel est monté un capteur wifi est considéré.

Les figures 1a et 1b montrent deux modes de réalisation d'un aspirateur 101, 101' configuré pour se déplacer de manière autonome dans une zone telle qu'une pièce ou un étage d'un bâtiment et pour nettoyer la zone.

L'aspirateur 101, 101' peut comporter des roues lui permettant de se déplacer.

Un circuit de traitement 107 intégré à l'aspirateur 101, 101' peut comporter des instructions relatives à la zone à nettoyer et relative à un programme de nettoyage. Par exemple, le circuit de traitement 107 peut indiquer à l'aspirateur 101, 101' le chemin à tracer dans une zone.

En outre, l'aspirateur 101, 101' peut comporter un capteur de position 103, par exemple un capteur LIDAR ou un capteur GPS, permettant à l'aspirateur 101, 101' de se repérer et de se déplacer dans une zone déterminée. Le capteur de position 103 permet à l'aspirateur 101, 101' de déterminer son emplacement actuel, par exemple par rapport à un point de référence tel que son point de recharge dont l'emplacement dont la zone est connue.

L'aspirateur 101, 101' peut comporter un capteur wifi 102 permettant de détecter l'intensité d'un signal wifi propagé dans la zone.

Dans un premier mode de réalisation montré dans la figure 1a, un aspirateur 101 qui ne comprend pas un capteur wifi 102 habituellement peut être aménagé afin d'intégrer un capteur wifi 102 dans l'aspirateur 101.

L'aménagement physique de l'aspirateur 101 n'est pas requis lorsque l'aspirateur 101 comprend dès le départ un capteur wifi 102 apte à détecter l'intensité d'un signal wifi. Dans ce cas, l'aménagement de l'aspirateur 101 est de nature logicielle, de telle sorte que l'aspirateur 101 peut utiliser le capteur wifi 102 et le capteur de position 103 afin d'établir une cartographie.

Le capteur wifi 102 peut être connecté au circuit de traitement 107 de l'aspirateur 101 et être contrôlé par le circuit de traitement 107.

Dans un deuxième mode de réalisation montré dans la figure 1b, l'aspirateur 101' peut comporter une interface de réception 108 configurée pour recevoir une interface de connexion 106 d'un module d'extension 105. Ainsi, le module d'extension 105 peut être branché à l'aspirateur 101' et peut être connecté au circuit de traitement 107 de l'aspirateur 101 '.

Le module d'extension 105 peut comprendre une pluralité de capteurs et notamment un capteur wifi 102 apte à détecter l'intensité d'un signal wifi. Lorsque l'aspirateur 101' met en oeuvre la première fonction, il peut faire utilisation du capteur wifi 102 du module d'extension 105 afin d'établir une cartographie.

L'avantage du module d'extension 105 réside dans le fait qu'il il n'est pas nécessaire d'aménager l'aspirateur 101' de façon spécifique pour établir une cartographie, et la présence d'une interface de réception 108 pour recevoir un module d'extension 105 est suffisante. Le module d'extension 105 peut être connecté à toute sorte de robot qui dispose d'une interface de réception 108 adaptée. Ainsi, un seul module d'extension 105 peut être utilisé pour différents robot, et différents types de paramètres peuvent être détectés avec un seul module d'extension 105 lorsque ce module d'extension 105 comprend des capteurs adaptés.

Dans les deux modes de réalisation selon les figures 1a et 1b, l'aspirateur 101, 101' comprend en outre une interface d'acquisition 104 configurée pour acquérir des données de topologie, par exemple une carte numérique de la zone à parcourir qui indique la position des murs ou d'autres obstacles.

Par exemple, l'interface d'acquisition 104 peut acquérir des données d'une carte numérique préenregistrée, afin d'indiquer à l'aspirateur 101, 101' position des parois ou de meubles dans la zone.

En alternative, l'aspirateur 101, 101' peut se déplacer dans la zone sans connaître la topologie de la zone, et l'interface d'acquisition 104 peut acquérir des données relatives à la topologie lors du déplacement de l'aspirateur 101, 101'. En effet, le capteur de position 103 peut comprendre un capteur de collision, et l'aspirateur 101, 101' peut détecter la présence d'obstacles dans la zone et déterminer les distances parcourues entre les obstacles.

Les données de topologie acquises par l'interface d'acquisition 104 peuvent être transmises au circuit de traitement 107.

Dans le mode de réalisation selon la figure 1b, l'interface d'acquisition 104 ainsi que le capteur de position 103 peuvent se trouver au niveau du module d'extension 105.

Les données de cartographie, i.e. les données mesurées du paramètre peuvent être sauvegardées dans le circuit de traitement 107, en lien avec l'emplacement respectif de l'aspirateur 101, 101' lors de la mesure.

Le circuit de traitement 107 peut transmettre les données de cartographie après leur acquisition, ou au fur et à mesure et lors de leur acquisition, pour une exploitation de ces données.

La figure 2 montre un ordinogramme d'un procédé pour obtenir des données de mesures d'une intensité de signal wifi à partir du capteur wifi 102 monté sur l'aspirateur 101, 101' tel que décrit dans les figures 1a ou 1b. Les étapes du procédé ne sont pas nécessairement mises en oeuvre dans l'ordre indiqué.

L'aspirateur 101, 101' peut se déplacer 201 dans une zone, ex. une pièce ou un bâtiment afin d'opérer sa première fonction, i.e. faire le ménage. Le déplacement peut se faire en fonction de la présence d'obstacles dans la zone. A cet effet, des données relatives à la topologie de la zone peuvent être acquises par l'interface d'acquisition 104 de l'aspirateur 101, 101', et l'aspirateur 101, 101' peut se déplacer sur la base de ces données de manière autonome.

Par exemple, l'aspirateur 101, 101' peut utiliser les données d'une carte numérique préenregistrée, ou déterminer, lors de son déplacement et au fur et à mesure la présence d'obstacles dans la zone et des distances parcourues entre les obstacles.

Le capteur wifi 102 peut être activé 202 lorsque l'aspirateur 101, 101' commence de se déplacer, ou pendant un déplacement et lorsque l'aspirateur 101, 101' entre dans une zone déterminée. L'aspirateur 101, 101' peut mesurer 203, lors de son déplacement, des valeurs de l'intensité de signal wifi et les associer à l'emplacement auquel les mesures ont été faites.

Les données de cartographie peuvent être transmises 204, par l'interface d'acquisition 104, à un serveur distant 109, ex. le smartphone d'un utilisateur de l'aspirateur 101, 101' ou un fournisseur de l'aspirateur 101, 101' ou un fournisseur du signal wifi.

Un exemple d'une représentation graphique d'une cartographie établie sur la base des données de cartographie pour un appartement dans un créneau déterminé et sur la base des données de topologie de cet appartement est montré dans la figure 3.

Cette cartographie montre les obstacles 402 présents dans l'appartement, notamment des parois et des meubles. La distribution de l'intensité du signal wifi est représentée par des lignes dont la densité varie en fonction de l'intensité du signal wifi. Une haute intensité 403 de signal wifi peut être visualisée par une haute densité de lignes, et une faible intensité 404 de signal wifi par une faible densité de lignes. Une autre option serait d'utiliser des nuances de gris pour représenter l'intensité locale du signal wifi.

La régularité de la collecte des données mesurées permet de générer une série temporelle de cartographies 401, permettant de représenter la variabilité de l'intensité du signal wifi dans le temps et dans l'espace.

En revenant au procédé selon la figure 2, les informations relatives à la cartographie 401 peuvent être analysées 205 et utilisées afin de résoudre un problème unitaire ou répétitif. Notamment, la cartographie 401 selon la figure 3 ou des séries de cartographies 401 peut être utilisée afin d'apporter des actions correctrices au signal ou aux obstacles de la zone afin d'améliorer l'intensité de signal wifi.

Un utilisateur peut consulter la cartographie 401 sur une application dédiée de son smartphone. L'utilisateur peut décider, sur la base de la cartographie 401, de déplacer des objets dans son appartement afin d'optimiser l'intensité de signal wifi dans son appartement.

Lorsque l'analyse de la cartographie 401 est faite au niveau du fournisseur du signal wifi, des conseils peuvent être élaborés et envoyés à l'utilisateur, par exemple sur l'application du smartphone. Par exemple, le fournisseur peut indiquer à l'utilisateur un endroit adapté dans son appartement pour l'installation d'un répéteur wifi ou de la box Internet.

Selon une autre fonction, l'aspirateur 101, 101' peut être reprogrammé 206 sur la base de la cartographie 401. Cette nouvelle fonction peut être illustrée à l'exemple un aspirateur 101, 101' qui est configuré pour établir, selon sa deuxième fonction, une cartographie d'un degré d'humidité dans un appartement.

Des cartographies du degré d'humidité établies antérieurement peuvent révéler que le degré d'humidité varie dans l'appartement d'une pièce à l'autre et en fonction de l'heure. Sur la base de ces connaissances déduites des cartographies, l'aspirateur 101, 101' peut être reprogrammé pour mettre en oeuvre sa première fonction lorsque le degré d'humidité dans l'appartement est au plus bas, afin de ne pas abîmer l'aspirateur 101, 101', dans une optique d'une utilisation plus durable de l'aspirateur 101, 101'. En outre, l'endroit de stationnement de l'aspirateur 101, 101', lorsqu'il n'est pas utilisé, peut être déterminé en fonction de la cartographie du degré d'humidité établi par l'aspirateur 101, 101'.

Dans un exemple non montré dans les figures, un robot peut comprendre deux capteurs et établir ainsi une cartographie de deux paramètres.

Par exemple, un aspirateur peut comprendre un capteur wifi et un capteur de température (souvent présent dans des batteries), permettant d'analyser l'intensité du signal wifi en fonction de la température.

Il peut s'avérer que l'intensité de signal wifi dépend de la température, et des actions influant sur la température peuvent être entreprises (ex. fermer une porte d'un appartement en été), dans l'optique d'optimiser l'intensité de signal wifi.

Dans un autre exemple non montré sur les figures, un aspirateur peut comprendre un capteur de température et un capteur de pression. Le capteur de température peut détecter, à un emplacement donné et pendant un laps de temps prédéterminé, une chute de température. Le capteur de pression peut mesurer la pression au même emplacement et pendant le même laps de temps. La mesure de la température et de la pression peuvent être réitérées, pendant des laps de temps prédéterminés successifs. Ainsi, la variation de température et de la pression peuvent être déterminées en fonction du temps, et l'origine des variations de la température/de la pression peuvent être identifiées. Par exemple, il peut être déterminé si une fenêtre a été ouverte (provoquant une variation de pression) ou pas.

Dans un autre exemple non montré sur les figures, un aspirateur comprend un capteur de température, un capteur d'humidité et un capteur de lumière. Le capteur de température peut détecter, à un emplacement donné et pendant un laps de temps prédéterminé, une chute de température.

Le capteur d'humidité peut mesurer un degré d'humidité et le capteur de lumière peut mesurer l'intensité de lumière au même emplacement et pendant le même laps de temps.

Les mesures de la température, du degré d'humidité et de l'intensité de lumière peuvent être réitérées, pendant des laps de temps prédéterminés successifs. Ainsi, les variations de température, du degré d'humidité et de l'intensité de lumière peut être déterminées en fonction du temps, et l'origine des variations de la température/ du degré d'humidité/ de l'intensité de lumière peuvent être identifiées. Par exemple, il peut être déterminé si la porte d'un frigo éclairé de l'intérieur a été ouverte (provoquant une augmentation du degré d'humidité et de l'intensité de lumière) ou pas.

La figure 4 montre un mode de réalisation du circuit de traitement 107 configuré pour mettre en oeuvre au moins une partie du procédé décrit en relation avec la figure 2.

Le circuit de traitement 107 comporte au moins une interface d'entrée 302 pour la réception de messages ou instructions, et au moins une interface de sortie 303 pour la communication avec des dispositifs externes 306 tels que le module d'extension 105 ou le serveur distant 109.

L'au moins une interface d'entrée 302 peut être configurée pour recevoir des instructions relatives à l'exécution de la première fonction et de la deuxième fonction.

Le circuit de traitement 107 comprend en outre une mémoire 304 pour stocker des instructions permettant la mise en oeuvre d'une partie au moins du procédé, les données reçues, et des données temporaires pour réaliser les différentes étapes et opérations du procédé telles que décrites précédemment.

Le circuit de traitement 107 peut comporter en outre un circuit de contrôle, par exemple :
- un processeur apte à interpréter des instructions sous la forme de programme informatique, ou
- une carte électronique dont les étapes du procédé de la divulgation sont décrites dans le silicium, ou encore
- une puce électronique programmable comme une puce FPGA pour « *Field-Programmable Gate Array »* en anglais, comme un SOC pour « *System On Chip »* en anglais ou comme un ASIC pour « *Application Spécifie Integrated Circuit »* an anglais.

Les SOC ou systèmes sur puce sont des systèmes embarqués qui intègrent tous les composants d'un système électronique dans une puce unique. Un ASIC est un circuit électronique spécialisé qui regroupe des fonctionnalités sur mesure pour une application donnée. Les ASIC sont généralement configurés lors de leur fabrication et ne peuvent être que simulés par un opérateur du circuit de traitement 107. Les circuits logiques programmables de type FPGA sont des circuits électroniques reconfigurables par l'opérateur du circuit de traitement 107.

Le circuit de traitement 107 peut être un ordinateur, un composant électronique, ou un autre appareil comportant un processeur couplé de manière opérationnelle à une mémoire, ainsi que, selon le mode de réalisation choisi, une unité de stockage de données, et d'autres éléments matériels associés comme une interface de réseau et un lecteur de support pour lire un support de stockage amovible et écrire sur un tel support non représentés sur la figure 4.

En fonction du mode de réalisation, la mémoire 304, l'unité de stockage de données ou le support de stockage amovible contiennent des instructions qui, lorsqu'elles sont exécutées par le circuit de contrôle 305, amènent ce circuit à effectuer ou contrôler l'au moins une interface d'entrée 302, l'au moins une interface de sortie 303, le stockage de données dans la mémoire 304 et/ou le traitement de données et/ou la mise en oeuvre d'au moins une partie du procédé selon la figure 2. Le circuit de contrôle 305 peut être un composant implémentant le pilotage du circuit de traitement 107.

En outre, le circuit de traitement 107 peut être mis en oeuvre sous forme logicielle, auquel cas il prend la forme d'un programme exécutable par un processeur, ou sous forme matérielle, ou « *hardware »,* comme un circuit intégré spécifique application ASIC, un système sur puce SOC, ou sous forme d'une combinaison d'éléments matériels et logiciels, par exemple un programme logiciel destiné à être chargé et exécuté sur un composant électronique décrit ci-avant tel que FPGA, processeur.

Le circuit de traitement 107 peut également utiliser des architectures hybrides, par exemple des architectures basées sur un CPU+FPGA, un GPU pour *« Graphics Processing Unit »* ou un MPPA pour « *Multi-Purpose ProcessorArray ».*

La présente divulgation permet d'établir une cartographie d'un paramètre dans une zone par un capteur monté sur un dispositif de type robot.

La présente divulgation ne se limite pas aux exemples de dispositifs, systèmes, procédés, utilisations et produits programmes informatiques décrits ci-avant, seulement à titre d'exemple, mais elle englobe toutes les variantes que pourra envisager la personne du métier dans le cadre de la protection recherchée.

## Revendications

1. Procédé d'obtention de données de mesures d'au moins un paramètre, à partir d'au moins un capteur (102), dans lequel ledit capteur (102) est monté sur un dispositif de type robot (101, 101') apte à se déplacer dans une zone pour opérer une première fonction, le procédé comportant :
- activer (202) le capteur (102) pour mesurer le paramètre au moins pendant un déplacement du dispositif (101, 101') dans la zone, et
- acquérir (203), selon une deuxième fonction du dispositif (101, 101'), distincte de la première fonction, des données pour établir une cartographie (401) dudit paramètre dans la zone.

2. Procédé selon la revendication 1, dans lequel le capteur (102) est activé (202) pour mesurer le paramètre pendant le déplacement du dispositif (101, 101') dans la zone pour opérer ladite première fonction.

3. Procédé selon l'une quelconque des revendications 1 et 2, dans lequel le paramètre est un paramètre parmi au moins une intensité de signal wifi, une température, un degré d'humidité, une pression, une intensité de lumière.

4. Procédé selon l'une quelconque des revendications précédentes, dans lequel l'acquisition des données pour établir la cartographie (401) du paramètre utilise des données de topologie de la zone d'une carte numérique préenregistrée correspondant à une topologie de la zone.

5. Procédé selon l'une quelconque des revendications 1 à 3, comportant une mesure de données de topologie de la zone, par détermination de distances parcourues par le dispositif (101, 101') entre des obstacles (402) présents dans la zone, pour obtenir une carte numérique de la zone.

6. Procédé selon l'une quelconque des revendications 4 et 5, dans lequel le dispositif (101, 101') est reprogrammé (206) pour utiliser les données de topologie de la zone, en vue d'une nouvelle fonction dans la mise en oeuvre de la première fonction.

7. Procédé selon l'une quelconque des revendications précédentes, dans lequel au moins deux capteurs sont montés sur le dispositif de type robot (101, 101'), le procédé comprenant :
- activer un premier capteur monté sur le dispositif de type robot (101, 101') pour mesurer un premier paramètre à un emplacement donné du dispositif de type robot (101, 101') pendant un laps de temps prédéterminé ;
- activer un deuxième capteur différent du premier capteur et monté sur le dispositif de type robot (101, 101') pour mesurer un deuxième paramètre audit emplacement donné du dispositif de type robot (101, 101') pendant ledit laps de temps prédéterminé ;
- réitérer la mesure du premier paramètre et du deuxième paramètre, et déterminer une survenance d'un évènement ou une absence dudit évènement dans la zone, sur la base des mesures du premier paramètre et du deuxième paramètre.

8. Procédé selon la revendication 7, dans lequel au moins trois capteurs sont montés sur le dispositif de type robot (101, 101'), le procédé comprenant en outre :
- activer un troisième capteur différent du premier capteur et du deuxième capteur et monté sur le dispositif de type robot (101, 101') pour mesurer un troisième paramètre audit emplacement donné du dispositif de type robot (101, 101 ') pendant ledit laps de temps ;
- réitérer la mesure du premier paramètre, du deuxième paramètre et du troisième paramètre, et déterminer une survenance d'un évènement ou une absence dudit évènement dans la zone, sur la base des mesures du premier paramètre, du deuxième paramètre et du troisième paramètre.

9. Produit programme informatique comportant des instructions qui, lorsque ces instructions sont exécutées par un circuit de traitement (107), conduisent le circuit de traitement (107) à mettre en oeuvre le procédé selon l'une quelconque des revendications 1 à 8.

10. Dispositif, de type robot (101, 101'), apte à se déplacer dans une zone pour opérer une première fonction, pour obtenir des données de mesures d'au moins un paramètre, le dispositif comportant un circuit de traitement (107) configuré pour la mise en oeuvre du procédé selon l'une quelconque des revendications 1 à 8.

11. Dispositif selon la revendication 10, comportant en outre un module d'extension (105) connecté au circuit de traitement (107) et comportant :
* au moins un capteur (102) configuré pour être activé et mesurer le paramètre au moins pendant un déplacement du dispositif (101') dans la zone ;
* une interface d'acquisition (104) configurée pour acquérir, selon la deuxième fonction du dispositif (101'), les données pour établir une cartographie (401) dudit paramètre dans la zone.

12. Dispositif selon la revendication 11, dans lequel le module d'extension (105) comporte en outre un capteur de position (103) configuré pour déterminer un emplacement du dispositif (101') lors du déplacement dans la zone.

13. Module d'extension (105) configuré pour être connecté à un circuit de traitement (107) d'un dispositif (101') apte à se déplacer dans une zone pour opérer une première fonction, le module d'extension (105) comportant :
* une interface de connexion (106) configurée pour connecter le module d'extension (105) au circuit de traitement (107) du dispositif (101');
* au moins un capteur (102) configuré pour être activé et mesurer au moins un paramètre pendant un déplacement du dispositif (101') dans la zone ;
* une interface d'acquisition (104) configurée pour acquérir, selon une deuxième fonction du dispositif (101'), distincte de la première fonction, des données pour établir une cartographie (401) dudit paramètre dans la zone.

14. Module d'extension selon la revendication 13, dans lequel l'interface d'acquisition (104) de données est connectée à un serveur distant (109) et configurée pour transmettre (204) au serveur distant (109) les données acquises.

15. Module d'extension selon l'une quelconque des revendications 13 et 14, dans lequel l'interface d'acquisition (104) de données est connectée au circuit de traitement (107) du dispositif (101') pour transmettre audit circuit de traitement (107) des données de cartographie (401) dudit paramètre, le circuit de traitement (107) étant programmé pour être configuré pour utiliser les données de cartographie (401) pour réaliser la première fonction.
